# EUROPEAN PATENT SPECIFICATION

(11) **EP 4 168 760 B1**
(45) Date of publication and mention of the grant of the patent: **22.10.2025**
(21) Application number: 21734327.6
(22) Date of filing: 18.06.2021
(51) Int. Cl.: G01J 1/04, G02B 6/28, G02B 6/42, G02B 6/255, G01J 1/44, G02B 6/10

(54) **FAST RELIABLE SUPERCONDUCTING SINGLE-PHOTON DETECTOR AND COST EFFECTIVE AND HIGH YIELD METHOD FOR MANUFACTURING SUCH**
SCHNELLER ZUVERLÄSSIGER SUPRALEITENDER EINZELPHOTONENDETEKTOR SOWIE KOSTENGÜNSTIGES UND HOCHAUSBEUTEVERFAHREN ZUR HERSTELLUNG DAVON
DÉTECTEUR DE PHOTON UNIQUE SUPRACONDUCTEUR RAPIDE ET FIABLE ET PROCÉDÉ RENTABLE ET À HAUT RENDEMENT POUR SA FABRICATION

(30) Priority: 19.06.2020 NL 2025873
(43) Date of publication of application: 26.04.2023
(73) Proprietor: Single Quantum B.V., 2629 HH DELFT (NL)
(72) Inventor: FOGNINI, Andreas Walter, 2512 EW The Hague (NL); GEVERS, Monique, 3021 BN Rotterdam (NL); LOS, Johannes Willem Nicolaas, 2353 EB Leiderdorp (NL)
(74) Representative: Arnold & Siedsma
(86) International application number: PCT/EP2021/066690
(87) International publication number: WO 2021/255275

(56) References cited:
- WO-A1-2014/026724
- CN-A- 110 350 077
- DE-A1- 102018 131 222
- PREBLE STEFAN: "UHNA Fiber - Efficient Coupling to Silicon Waveguides", APPLICATION NOTE NUAPP-3, 10 March 2016 (2016-03-10), pages 1 - 3, XP055871383, Retrieved from the Internet <URL:https://www.coherent.com/content/dam/coherent/site/en/resources/application-note/components-and-accessories/specialty-optical-fibers/uhna-fiber-efficient-coupling-to-silicon-waveguides.pdf> [retrieved on 20211209], DOI: 10.1016/j.jtbi.2019.03.012
- ANONYMOUS: "Ultra-High NA Select Cutoff Single-Mode Fiber", 9 December 2021 (2021-12-09), pages 1 - 4, XP055871406, Retrieved from the Internet <URL:https://coherentinc.force.com/Coherent/specialty-optical-fibers/UHNA7?cclcl=en_US> [retrieved on 20211209]
- ESMAEIL ZADEH IMAN ET AL: "Efficient Single-Photon Detection with 7.7 ps Time Resolution for Photon-Correlation Measurements", vol. 7, no. 7, 10 June 2020 (2020-06-10), pages 1780 - 1787, XP055779999, ISSN: 2330-4022, Retrieved from the Internet <URL:http://pubs.acs.org/doi/pdf/10.1021/acsphotonics.0c00433> DOI: 10.1021/acsphotonics.0c00433

## Description

The present invention relates to improved Superconducting Nanowire Single-Photon Detectors (SNSPDs), and a method for manufacturing such SNSPDs with increased yield, lower costs, and better performance.

In the current information age, our lives rely on the creation, distribution, and detection of short light pulses forming the Internet. This demand for high data throughput has pushed the speed of laser modulators and detectors close to the 1ps time limit. However, to reach these speeds, current telecom detectors require at least a thousand photons per pulse. The amount of photons per pulse has been pushed to the physical limit of a single-photon, while preserving a good time response.

To that end, SNSPDs were developed to detect one single-photon, more than a thousand times more sensitive than the best telecom detectors available today, while maintaining a time resolution on the order of 20ps full width at half maximum. However, the best superconducting detectors cannot operate faster than 100 MHz at telecom wavelength while maintaining their full efficiency.

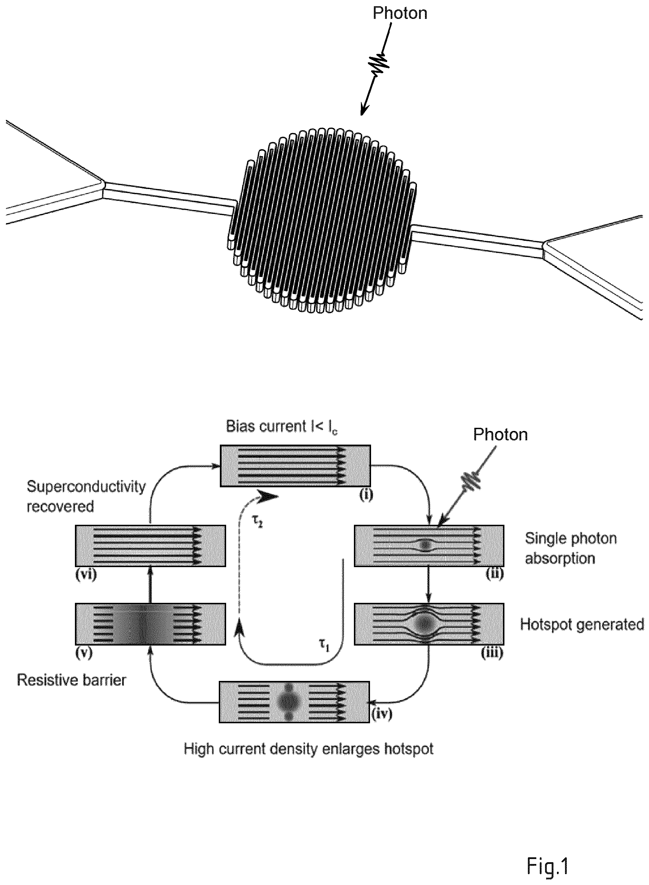

Figure 1 illustrates the principle behind a superconducting nanowire single-photon detector (SNSPD). In such detectors, single-photons are counted with extremely high sensitivity by detecting the transition from the superconducting to resistive state of a nanowire. A SNSPD detector is constituted by a thin film of superconducting material shaped into a meandering nanowire through nanofabrication processes. This pattern enables to cover a large surface area, collecting the whole output of an optical fiber, while constituting a single path for the current. The detectors are operated at low temperatures such that the nanowire is superconducting (e.g. at 2.5 Kelvin) and a constant current below the critical current of the superconductor is applied to the device. The nanoscale cross section gives the photon detectors extremely high sensitivity upon absorption of just a single-photon.

Once a single-photon is absorbed in the meandering nanowire, superconductivity is locally broken. As a result, the current is directed towards the amplification electronics and creates a voltage pulse. After the photon is absorbed, superconductivity recovers in the nanowire within a short time and the SNSPD is ready to detect the next photon.

In applications such as lifetime measurements of photoluminescence and photon correlation measurements, high time resolution of photon detectors is of great importance. The time resolution of single-photon detectors is characterized by the full width at half maximum (FWHM) of the variation in the temporal delay from the absorption of a photon to the generation of an output electrical pulse, which is defined as the timing jitter.

To obtain a low timing jitter, cryogenic amplification is used. A typical SNSPD with cryogenic amplifier in the art may reach a less than 15 ps FWHM timing jitter.

CN110350077 discloses a large polarization extinction ratio micro/nano coupled superconducting nanowire single photon detector. The single-photon detector comprises a substrate, a superconducting nanowire, a micro/nano fiber and optical glue, wherein the superconducting nanowire is arranged on a surface of the substrate, the micro/nano fiber is arranged on the substrate and bridges the superconducting nanowire, the optical glue is arranged on the substrate and is cured to wrap the peripherals of the superconducting nanowire and the micro/nano fiber, and the optical glue has a preset refractive range so that TM-mode incident light from incident light in the micro/nano fiber is cut off and TE-mode incident light is allowed to pass by. By the detector, the absorption rate of the TE-mode incident light is farther larger than that of the TM-mode incident light, thus, the detection efficiency of the TE-mode incident light also can be farther higher than that of the TM-mode incident light, and the detector has relatively large polarization extinction ratio; and moreover, the detector has the advantages of no need of grating filtering, simple structure, simple fabrication process, small incident light loss, high detection efficiency and the like.

DE102018131222A1 discloses a single photon detector device for detecting an optical signal, comprising an optical fiber and at least one nanowire, the optical fiber having a core region and a cladding region and being designed for this purpose the optical signal is to be guided along an optical axis, wherein, with respect to the optical axis, a first section of the optical fiber is an input section for the optical signal and a second section of the optical fiber is a detector section and wherein the nanowire becomes superconductive at a predetermined temperature and is designed to generate an output signal as a function of the optical signal in the superconductive state. Provision is made for the nanowire to extend essentially along the optical axis of the optical fiber in the detector region of the optical fiber. A single photon detector device is thus provided which has a simple structure, high efficiency, a high detection rate and a high spectral bandwidth. WO2014/026724 discloses an integrated, hybrid nanophotonic- superconducting device that functions as a scalable spectrometer with single photon intensity resolution and picosecond timing resolution. The device is realized on a single chip and contacted optically by optical fibers, thus compatible with optical imaging systems through a fiber, coupling port.

### SUMMARY

It is an object, among objects, of the invention to provide fast and reliable superconducting single-photon detectors as well as a cheap and high yield method for manufacturing such detectors.

According to the invention, a single-photon detector apparatus with the features of claim 1 and a manufacturing method with the steps of claim 9 are provided to a address these objects.

The single-photon detector apparatus is provided comprising a large core optical fiber with a core diameter larger than 8 µm, a small core optical fiber with a core diameter smaller or equal to 5 µm, a splicing between the large core optical fiber and the small core optical fiber, a super conducting nanowire having a surface area configured to receive all photons emitted from the small core optical fiber.

In this way, the nanowire can cover a smaller area while remaining compatible with standard fibers, which broadens the field of applications beyond fundamental research applications. Because the nanowire has to cover a smaller surface area, due to the use of the small core optical fiber, the nanowire is shorter and easier to make and the manufacturing process is improved as it gives a higher yield of high-quality detectors being produced. Additionally, their performance is improved such as the dead time of the detectors and timing jitter, which is linked to the length of the nanowire, becomes shorter, and thus making the detection faster and allowing the single-photon detectors to be used in more applications.

One can think for instance of applying the invention to remotely sense chemicals, to monitor industrial processes with additional safety and efficiency. Optical diagnostic tools may benefit from the present invention by improving as weak infrared pulses at the ps level can be directly measured. Optical communication may benefit as communication can be performed at the physical limit of the single-photon level, enhancing energy efficiency which is especially desirable for communication with micro-satellites. The advent of quantum cryptography may gain from our fast and reliable single-photon detectors. In medicine, this technology may generate breakthroughs in spectroscopic and microscopic measurements, allowing the detection of illnesses at an earlier stage - increasing therapy effectiveness.

Although a splicing is preferably used between the large core optical fiber and the small core optical fiber, more generally a taper may be used between the large core optical fiber and the small core optical fiber. More preferably an adiabatic taper may be used between the large core optical fiber and the small core optical fiber. In particular the taper may obtained by splicing two separate optical fibers, one with a large core and one with a small core. Alternatively the taper may be the result of stretching a large core optical fiber into an optical fiber with a small core diameter. In this way, all photons received by the large core optical fiber may be transmitted through the taper to the small core optical fiber.

The free-end of the small core optical fiber is butt-coupled to the superconducting nanowire. In this way all the photons emitted from the small core optical fiber may be received by the surface area of the superconducting nanowire.

In a preferred embodiment, the surface area has a diameter in the range of 4 - 10 µm, preferably 6 - 9 µm. In a preferred embodiment the splicing is formed by an adiabatic taper. In other words, the adiabatic taper is formed by a splicing.

In a preferred embodiment, the small core optical fiber may have a core diameter between 1.5 µm and 4 µm, more preferably between 1.6 µm and 3.8 µm. In this way the size of the detector is made smaller. Preferably, the small core optical fiber may be one from the UHNA-family, a UHNA3 having a core diameter of 1.8 µm, or a 980 HP fiber, a 980 HP fiber having a core diameter of 3.6 µm. In this way, the size of the detector may be reduced to a diameter smaller than 10 µm, preferably smaller than 8 µm.

In a preferred embodiment, the large core optical fiber may be a SMF28 fiber. In this way a connection from the large core fiber inside the detector apparatus to a standard telecom fiber outside the detector apparatus is possible, extending the fields of applications.

In a preferred embodiment, the splicing is configured to have less than 8 percent transmission losses. In this way, a reliable detection is ensured.

In a preferred embodiment, a detecting system is provided and configured to detect a single-photon coming from the large core optical fiber, by detecting the transition of the nanowire from the superconductive to the resistive state upon the absorption of a single-photon. In this way single-photons may be counted in an efficient way.

Further, a method of manufacturing a small single-photon detector is provided. The method comprises the steps of:
- Splicing together a large core optical fiber and a small core optical fiber, the large core optical fiber having a core diameter larger than 8 µm and the small core optical fiber having a core diameter smaller or equal to 5 µm,
- fabricating a superconducting nanowire having a surface area configured to receive all photons emitted from the small core optical fiber, and
- placing the free-end of the small core fiber relative to the superconducting nanowire such that, in use, all photons emitted from the small core optical fiber are received by the surface area of the superconducting nanowire.

In this way, a smaller surface area is etched, less electron-beam write time is required, such that costs may be reduced and the manufacturing method rendered cheaper. A shorter nanowire also increases the chances of a successful etching process, and therefore the method achieves a higher yield of functioning viable detectors, contributing to less material and energy loss and a cheaper manufacturing process. Additionally, the method enables saving considerable testing time of the devices in the test-lab as more detectors will pass the quality requirements.

Although splicing together a large core optical fiber and a small core optical fiber is preferably performed, more generally forming a taper between the large core optical fiber and the small core optical fiber may be performed. More preferably forming an adiabatic taper between the large core optical fiber and the small core optical fiber may be performed. In particular a taper may be formed by fusion splicing two separate optical fibers, one with a large core and one with a small core. Alternatively forming the taper may comprise stretching a large core optical fiber into an optical fiber with a small core diameter. In this way, all photons received by the large core optical fiber may be transmitted through the adiabatic taper to the small core optical fiber.

The step of placing comprises butt-coupling the free-end of the small core fiber to the superconducting nanowire. In this way all the photons emitted from the small core optical fiber may be received by the surface area of the superconducting nanowire. Preferably the step of butt-coupling comprises butt-coupling the free-end of the small core fiber to the superconducting nanowire using a mating sleeve.

In a preferred embodiment, the step of splicing together a small core optical fiber and a large core optical fiber may comprise fusion splicing the fibers with an arc time between 5000 ms and 8000 ms, preferably between 5800 ms and 6200 ms. In this way, an optimal power transmission is achieved, increasing the probability of the detection.

In a preferred embodiment, an arc power in the range of 30 to 45 bit is used. More preferred is an arc power of 37 bit. Such a definition of arc power is known in the art. The arc power may for instance be in a range of 0 to 100 bit, wherein 0 bit is equivalent to a first arc current such as about 10.5 mA, and wherein 100 bit is equivalent to a second arc current such as about 14.5 mA.

In a preferred embodiment, the method may comprise connecting to the nanowire detector a detecting system configured to detect a single-photon in the large core optical fiber, by detecting the transition of the nanowire from the superconductive to the resistive state upon the absorption of a single-photon. In this way single-photons may be counted in an efficient way.

In a preferred embodiment, the step of splicing together a small core optical fiber and a large core optical fiber may further comprise, prior to fusion splicing, the steps of a) cutting each fiber, stripping, cleaning the fibers from their protective coating, b) cleaving the fibers at a predetermined cleaving angle.

In a preferred embodiment, the step of verifying the cleave angle may be provided and if necessary the steps a) and b) may be repeated. In this way errors may be corrected and a proper operation may be ensured.

In a preferred embodiment, the step of fabricating the superconducting nanowire may comprise sputtering a superconducting material onto a silicon wafer coated with dielectric materials to form a cavity, etching the nanowire in the cavity and etching the silicon wafer into key-hole shaped chips containing the nanowire. In this way the nanowire is provided in a practical shape, especially for the further coupling step, as the key-hole shape locks easily into a mating sleeve for a proper butt-coupling.

In a preferred embodiment the step of placing the free-end of the small core fiber relative to the superconducting wire comprises coupling the free-end of the small core fiber to the superconducting nanowire.

In a preferred embodiment, the step of coupling the free-end of the small core fiber to the superconducting nanowire may comprise butt-coupling the free-end of the small core fiber to the superconducting nanowire using a mating sleeve. In this way all the light is collected from the small core optical fiber onto the surface of the superconducting nanowire enabling a single-photon detection. The mating sleeve may also reduce the amount of stray light that is detected, if any. Furthermore, the mating sleeve increases mechanical stability.

In a preferred embodiment, testing the transmission losses of the splicing may be performed prior to coupling the spliced fiber to the superconductive nanowire. In this way the reliability of the detectors obtained by following the manufacturing method of the invention may be further increased. In particular in a preferred embodiment the testing may comprise splicing twice, measuring the transmission loss and dividing the transmission loss found for the double splice by two to obtain the transmission loss per splice. Alternatively, the testing may involve measuring the transmission loss per splice by an integrating sphere power sensor. In this precise testing results may be obtained, contributing to reducing testing time for an efficient manufacturing method.

In a preferred embodiment, there is provided a single-photon detector apparatus obtainable by the method according to any one of above embodiments.

### BRIEF DESCRIPTION OF THE FIGURES

This and other aspects of the present invention will now be described in more detail, with reference to the appended drawings showing preferred embodiments of the invention. Like numbers refer to like features throughout the drawings
Figure 1 illustrates the principle of single-photon detection according to the prior art.
Figure 2 illustrates a schematic representation of a detector according to the invention.
Figure 3 shows the flowchart of the method according to the invention for manufacturing a detector according to Figure 2.
Figure 4 illustrates an exploded view of the elements involved during step S3 of Figure 3.

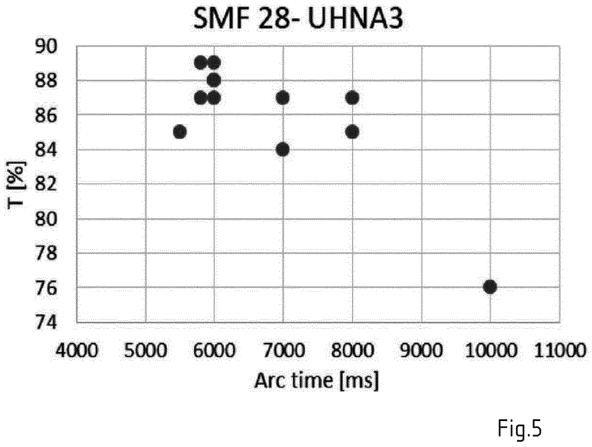

Figure 5 illustrates the power transmission of spliced SMF28-UHNA3 fibers as a function of the arc time for fusion splicing at a power of 37 Bits.

### DESCRIPTION OF EMBODIMENTS

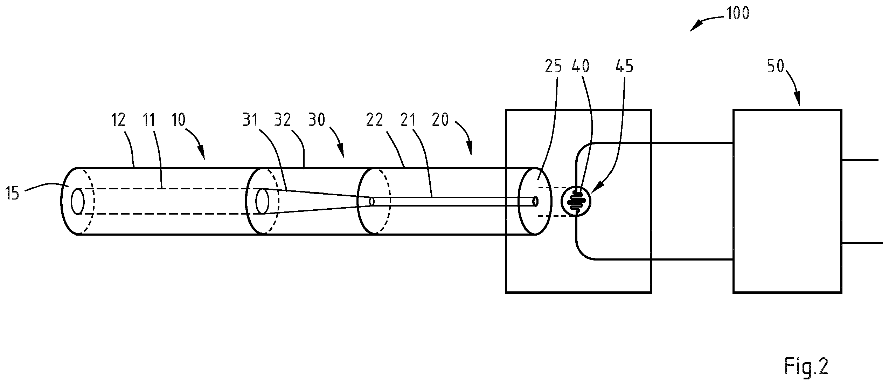

Figure 2 illustrates a schematic representation of a detector 100 according to the invention. A Single-photon detector 100 comprises a large core optical fiber 10, a small core optical fiber 20, a splicing 30 between the large core optical fiber 10 and the small core optical fiber 20, a super conducting nanowire 40 covering a surface area 45 configured to collect the whole light output of the small core optical fiber 20, a detecting system configured 50 to detect a single-photon in the large core optical fiber 10, by detecting the transition of the nanowire 40 from the superconductive to the resistive state upon the absorption of a single-photon.

The large core optical fiber 10 may have a core 11 with a diameter larger than 8 µm. The large core optical fiber 10 may be a standard telecom fiber, like a SMF28-Ultra fiber for instance, but other fibers with much larger cores may also be envisaged. Photonic crystal fibers can have core diameters up to several tens of microns, while fibers for multimode applications can go till a millimeter scale of its core diameter. An optical fiber may be selected with a core diameter depending on the fibers used on the outside of the detector and/or the field of application.

The small core optical fiber 20 may have a core 21 with a diameter smaller or equal to 5 µm, preferably between 1.5 µm and 4 µm, more preferably between 1.6 µm and 3.8 µm. In particular, the small core optical fiber 20 may be a UHNA-x fiber, UHNA3 for instance having a core diameter of 1.8 µm, or a 980 HP fiber having a core diameter of 3.6 µm.

The large core optical fiber 10 may have an external coating 12 while the small core optical fiber may have an external coating 22, such that the diameters of both fibers 10 and 20 may be substantially the same.

The fibers 10 and 20 are spliced together such that the light passing through the fiber 10 is substantially not scattered nor reflected back by the splice 30 but travels further in the fiber 20. In particular the splicing is configured to have less than 8 percent transmission losses. The splicing 30 is formed by an adiabatic taper 31 between the cores 11 and 21 of the fibers 10 and 20 allowing for a highly efficient mode conversion between the two fibers 10 and 20. In particular a transmission loss of the spliced fibers is preferably low, more preferably lower than 10 percent. A protecting sleeve 32 in the form of shrinking tube with a steel wire may be present around the taper 31 protecting the splicing 30 from the outside and providing mechanical stability to the splice. Each fiber has a first and second end, the fibers being spliced together at their respective first ends, while their second ends are free for further connection. The second end 15 of the fiber 10 may receive photons, while the second end 25 of the fiber 20 is butt-coupled to the super conducting nanowire 40. The coupling between the second end 25 and the nanowire 40 is such that the surface 45 on which the nanowire 40 is fabricated captures all the light or photons coming out of the second end 25 of the fiber 20. The butt-coupling may be realized by a sleeve 60 mounted on a PCB hosting the silicon chip on which the nanowire 40 is fabricated. The end 25 of the fiber 20 is pushed in said sleeve 60 until it is set flush with the silicon chip.

The diameter of the surface 45 of the SNPD has to be designed larger than the fiber core 21 to capture all the light coming out of the fiber 20. The size of the surface 45 on which the nanowire 40 is fabricated may be set to the minimum necessary to collect the whole output of the small core fiber 20. For a certain range of wavelengths, the mode field diameter of the small core fiber being larger than the core diameter implies a slightly larger size of detector than the core diameter of the small core fiber. Additionally, some light diffraction on the sides as well as some room for alignment issues may have to be taken into account. However, compared to the prior art using large core fibers directly onto the detector, the present arrangement reduces the size of the necessary surface 45 for the nanowire 40, and thus the length of said nanowire 40 as well.

By making the nanowire 40 shorter, the dead time of the detection, jitter time, becomes also shorter since the dead time is linked to the length of the wire, thus making the detection faster. As explained in the introduction, a faster detector broadens the field of applications.

In addition, by using a large core optical fiber on the input the compatibility with standard telecom fibers is ensured, broadening even further the field of applications beyond fundamental research applications.

In practice for a UHNA3 with a core of 1.8 µm and a mode field diameter of 4.1 µm at 1550 nm, as well as for a 980HP with a core of 3.6 µm and a mode field diameter of 6.8 µm at 1550 nm, a detector having a nanowire surface 45 with 8 µm of diameter may be designed. The prior art solutions showed detectors typically with 16 µm diameter at 1550 nm. The size of the detector of the present invention represents thus a reduction of at least half the diameter size and a quarter in detector area 45.

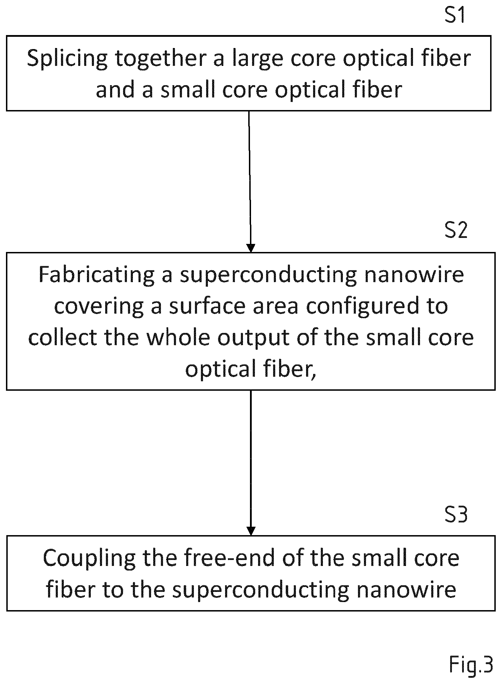

Next, a method of manufacturing a small single-photon detector according to the present invention will be explained. The method is illustrated in Figure 3 and comprises the step S1 of splicing together a large core optical fiber and a small core optical fiber, such that light passing through the fiber is not scattered nor reflected back by the splice, the large core optical fiber having a core diameter larger than 8 µm and the small core optical fiber having a core diameter smaller or equal to 5 µm. This step will be detailed further in the rest of the description.

The second step S2 comprises fabricating a superconducting nanowire covering a surface area configured to collect the whole output of the small core optical fiber. This step is therefore dependent on the size and characteristics of the small core fiber selected and can be performed once a small core optical fiber has been chosen. In figure 3, step S2 has been represented as consecutive to step S1. However, the step of nanowire fabrication in itself is independent from the splicing step such that the step S2 could actually be performed before, after, or simultaneously with step S1 provided that the type of small core optical fiber used has been selected.

Fabrication of SNSPDs involves coarsely the following sub-steps:
First, a superconducting material is sputtered onto a cleaned silicon wafer already coated with dielectric materials to form a distributed-Bragg-reflector or another type of cavity. After this the Gold contacts and alignment markers are created using optical lithography and Gold evaporation.
Second, by means of e-beam lithography a nanowire is patterned and finally etched out.
In a third sub-step, the nanowire is coated with another dielectric material stack to form a top cavity and anti-reflection coating.

In a last sub-step, the silicon is etched into key-hole shapes by means of a Bosch-etching process. A key-hole shaped silicon chip contains the superconducting nanowire and the gold contacts connected to both ends of said nanowire for later bonding to a PCB.

It is further noted that the fabrication step S2 of the present invention will require less electron-beam write time than a fabrication step for a detector of the prior art given the reduction of the surface area 25 on which the nanowire must be fabricated. In this way, the costs may be reduced and the manufacturing method according to the invention is cheaper.

Besides a shorter nanowire is easier to fabricate, such that a manufacturing method according to the invention has a higher yield of functioning viable detectors than the prior art and saves valuable device testing time since more high-quality detectors are made

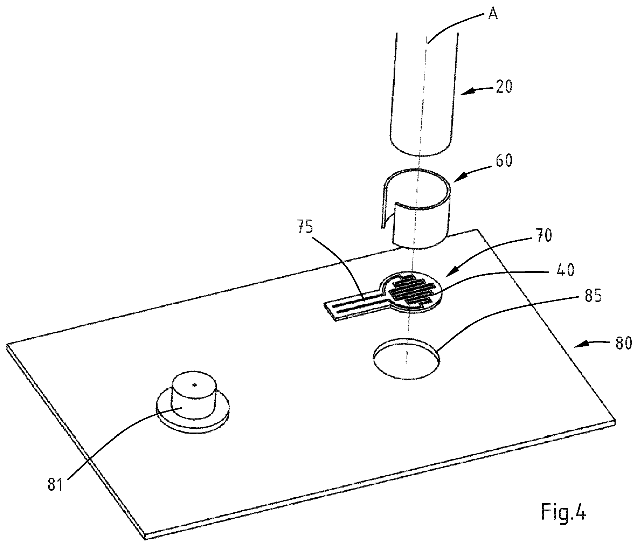

Next the step S3 comprises placing the free-end of the small core fiber 20 relative to the superconducting nanowire 40 such that, in use, all photons emitted from the small core optical fiber are received by the surface area of the superconducting nanowire. More in particular S3 comprises coupling the free-end 25 of the small core fiber 20 to the key-hole shaped chip carrying the superconducting nanowire 40. Figure 4 illustrates in an exploded view along an axis A the different elements involved in the coupling step S3. The coupling is a so called butt-coupling and may comprise the steps of inserting along the axis A a key-hole shaped silicon chip 70, carrying the nanowire 40 and the contacts 75, into the mating sleeve 6, inserting the free-end 25 of the small core fiber 20 inside said sleeve 60 till it flushes with the silicon chip 70 and is locked into place, fixing the mating sleeve 60 to a Printed Circuit Board (PCB) 80, for instance by inserting it in a hole 85 and using glue, bonding the contacts 75 of the chip 70 to a connector 81 on the PCB 80. The key-hole shaped chip 70 fabricated in step S2 comprises a circular shaped portion containing the surface 45 on which the nanowire 40 is meandering and an elongated portion on which the nanowire has straight portions for connection to gold contacts 75. The key-hole shaped chip 70 is inserted into the mating sleeve 60 to align the optical fiber 20 precisely to the SNSPD by means of butt-coupling to collect the whole output of the small core optical fiber 20 onto the surface 45 of the superconducting nanowire 40 and allows connection to a connector 81 for further connection to the detector system 50. This step S3 is consecutive to the realization of both steps S1 and S2.

For splicing the fibers together according to step S1, a series of steps are followed. The procedure will be described in detail for splicing a SMF28 fiber with a UHNA fiber.

First the SMF28 fiber may be cut at a length of at least 40 cm. The UHNA fiber may be to cut at any length provided there would be enough fiber to splice it twice, if the first time did not go well. Additionally it will be understood that the length is to be adapted to reach the detector as well as to fit into the fiber splicer.

After being cut a protection sleeve may be placed over one of the fibers. The fiber may be placed in a fiber holder as known in the art, while making sure that the fiber is not bend to the side or upwards. The fiber may stay in this holder for the rest of the process. The fiber may then be heated for about 5 seconds before that the protective coating may then be carefully stripped away using two flat blades. If the blades do not strip the full coating, a second effort might be necessary. To make sure the bare fiber is completely clean of coating grit, it is cleaned using ethanol and lint free tissue.

When the fiber is free of the coating grit, it can be cleaved using known cleaving devices. Cleaving, contrary to cutting, does not use a tool going through the object but generates a scratch, used to break the glass clean. The cleaving angle should be as close to 90 degrees as possible. Should the cleaving angle be too much off, the cleaving step should be repeated. The diamond blade should make a straight angle with the fiber to make a straight cut. If the fiber is not placed properly in the fiber holder or it is not fully cleaned, it will have influence on the cleaving angle.

The following step is to check the fiber using a fiber splicer. The fiber holders with the fibers are placed in a fiber splicer, for instance the Fujikura FSM-100P+. The splicer aligns the fibers automatically and measures the cleave angle. If this angle is bigger than 1.0 degrees, the fiber should be cleaved again to ensure a good splice. The splicer also shows an image of the fiber, if there are bumps or grit or any irregularities the fiber should be stripped, cleaned and cleaved again. These irregularities cause relatively poor fiber transmission.

The next step is the fusion splicing per se inside the fiber splicer. The arc power and arc time are parameters to be set for fusion splicing. In particular, it was found that an arc time of between 5000 ms and 8000 ms give the best results in terms of power transmission (T) for the SMF28-UHNA3 splice, as is shown in figure 4, in particular for an arc power of 37 bit. In the devices used in the present example, viz. the Fujikura FSM-100 series, including the FSM-100M+ or the FSM-100P+, the arc power can be varied from 0 bit, equivalent to a first arc current such as about 10.5 mA, to 100 bit, equivalent to a second arc current such as about 14.5 mA. Figure 4 illustrates power transmission results obtained for several splices using different arc times. For arc times of between 5800 and 6200 ms the lowest transmission losses were observed.

The transmission T of the spliced fiber was checked by splicing twice from SMF28 to UHNA3 to SMF28. In this case the head of the SMF28 was connected to the power meter. The transmission loss was measured by dividing the loss by two because the fiber was spliced twice. Doing this measurement for two different fibers, the transmission of the double spliced fibers was 85% and 87%, roughly saying that the transmission loss per splice was 7.5% and 6.5% respectively. In other words, reaching a transmission of 93.5% if the fiber would have been spliced once. It is noted that a 93.5 % transmission is a 0,29dB loss, wherein the loss in dB may be related by -10 log(T/100).

An alternative and preferred method to measure the transmission loss is by an integrating sphere power sensor. This type is able to cope with the large light divergence form the small core optical fibers such as, but not limited to, UHNA fiber type and 980HP fibers. This method has the advantage that the power transmission from a single splice can be accurately measured and no assumption of splice uniformity as in the double splice approach needs to be made. The data in figure 4 was measured by an integration sphere detector type.

Whilst the principles of the invention have been set out above in connection with specific embodiments, it is understood that this description is merely made by way of example and not as a limitation of the scope of protection which is determined by the appended claims.

## Claims

1. Single-photon detector apparatus (100) comprising:
- a large core optical fiber (10) with a core (11) diameter larger than 8 µm,
- a small core optical fiber (20) with a core (21) diameter smaller or equal to 5 µm,
- a taper (30) between the large core optical fiber (10) and the small core optical fiber (20),
- a superconducting nanowire (40) having a surface area (45) configured to receive all photons emitted from the small core optical fiber (20), wherein the free-end of the small core optical fiber (20) is butt-coupled to the superconducting nanowire (40).

2. Single-photon detector apparatus according to any of the above claims, wherein the small core optical fiber (20) has a core diameter between 1.5 µm and 4 µm, preferably between 1.6 µm and 3.8 µm.

3. Single-photon detector apparatus according to any of the above claims, wherein the small core optical fiber (20) is one of a fiber from the UHNA-family or a 980 HP fiber.

4. Single-photon detector apparatus according to any of the above claims, wherein the large core optical fiber (10) is an SMF28 fiber, preferably a SMF28-Ultra.

5. Single-photon detector apparatus according to any of the above claims, wherein the taper is an adiabatic taper.

6. Single-photon detector apparatus according to any of the above claims, wherein the taper is formed by a splicing, wherein preferably the splicing (30) is configured to have less than 8 percent transmission losses.

7. Single-photon detector apparatus according to any of the above claims, further comprising a detecting system (50) configured to detect a single-photon coming from the large core optical fiber (10), by detecting the transition of the nanowire (40) from the superconductive to the resistive state upon the absorption of a single-photon.

8. Single-photon detector apparatus according to any of the above claims, wherein the surface area (45) has a diameter in the range of 4 - 10 µm, preferably 6 - 9 µm.

9. Method of manufacturing a single-photon detector apparatus (100), comprising the steps of:
- forming a taper between a large core optical fiber (10) and a small core optical fiber (20), the large core optical fiber (10) having a core (11) diameter larger than 8 µm and the small core optical fiber (20) having a core (21) diameter smaller or equal to 5 µm,
- fabricating a superconducting nanowire (40) having a surface area (45) configured to receive all photons emitted from the small core optical fiber (20),
- placing the free-end of the small core fiber (20) relative to the superconducting nanowire (40) such that, in use, all photons emitted from the small core optical fiber (20) are received by the surface area (45) of the superconducting nanowire, wherein the step of placing comprises butt-coupling the free-end of the small core fiber (20) to the superconducting nanowire (40).

10. Method according to the previous claim, wherein the step of butt-coupling comprises butt-coupling the free-end (25) of the small core fiber (20) to the superconducting nanowire (40) using a mating sleeve (60).

11. Method according to any of the above method claims, wherein forming a taper comprises forming an adiabatic taper.

12. Method according to any of the above method claims, wherein forming a taper comprises splicing together the large core optical fiber (10) and the small core optical fiber (20, wherein preferably the step of splicing together a small core optical fiber (20) and a large core optical fiber (10) comprises fusion splicing the fibers with an arc time between 5000 ms and 8000 ms, more preferably between 5800 ms and 6200 ms, wherein more preferably the fusion splicing is performed at an arc power in the range of 30 to 45 bit, preferably 37 bit.

13. Method according to claim 12 , wherein the step of splicing together a small core optical fiber (20) and a large core optical fiber (10) further comprises, prior to fusion splicing, the steps of:
a) cutting each fiber (10, 20), stripping, cleaning the fibers (10, 20) from their protective coating (12, 22),
b) cleaving the fibers (10, 20) at a predetermined cleaving angle, further preferably comprising the step of verifying the cleave angle and if necessary repeating the steps a) and b).

14. Method according to any of the above method claims, further comprising connecting a detecting system (50) configured to detect a single-photon in the large core optical fiber (20), by detecting the transition of the nanowire (40) from the superconductive to the resistive state upon the absorption of a single-photon, and/or wherein the step of fabricating the superconducting nanowire (40) comprises sputtering a superconducting material onto a silicon wafer, the wafer being coated with dielectric materials to form a cavity, etching the nanowire (40) in the cavity and etching the silicon wafer into key-hole shaped chips (70) containing the nanowire (40).

15. Single-photon detector apparatus obtainable by the method according to any one of claims 9-14.

## Patentansprüche

1. Einzelphotonendetektorvorrichtung (100), umfassend:
- eine optische Faser (10) mit großem Kern mit einem Durchmesser des Kerns (11), der größer als 8 µm ist,
- eine optische Faser (20) mit kleinem Kern mit einem Durchmesser des Kerns (21), der kleiner als oder gleich 5 µm ist,
- eine Verjüngung (30) zwischen der optischen Faser (10) mit großem Kern und der optischen Faser (20) mit kleinem Kern,
- einen supraleitenden Nanodraht (40), der eine Oberfläche (45) aufweist, die konfiguriert ist, um alle Photonen zu empfangen, die von der optischen Faser (20) mit kleinem Kern emittiert werden, wobei das freie Ende der optischen Faser (20) mit kleinem Kern mit dem supraleitenden Nanodraht (40) stumpf gekoppelt ist.

2. Einzelphotonendetektorvorrichtung nach einem der vorstehenden Ansprüche, wobei die optische Faser (20) mit kleinem Kern einen Kerndurchmesser zwischen 1,5 µm und 4 µm, vorzugsweise zwischen 1,6 µm und 3,8 µm, aufweist.

3. Einzelphotonendetektorvorrichtung nach einem der vorstehenden Ansprüche, wobei die optische Faser (20) mit kleinem Kern eine von einer Faser aus der UHNA-Familie oder eine 980 HP-Faser ist.

4. Einzelphotonendetektorvorrichtung nach einem der vorstehenden Ansprüche, wobei die optische Faser (10) mit großem Kern eine SMF28-Faser, vorzugsweise eine SMF28-Ultra, ist.

5. Einzelphotonendetektorvorrichtung nach einem der vorstehenden Ansprüche, wobei die Verjüngung eine adiabatische Verjüngung ist.

6. Einzelphotonendetektorvorrichtung nach einem der vorstehenden Ansprüche, wobei die Verjüngung durch eine Spleißung ausgebildet wird, wobei vorzugsweise die Spleißung (30) konfiguriert ist, um weniger als 8 Prozent Übertragungsverluste aufzuweisen.

7. Einzelphotonendetektorvorrichtung nach einem der vorstehenden Ansprüche, ferner umfassend ein Detektionssystem (50), das konfiguriert ist, um ein Einzelphoton zu detektieren, das aus der optischen Faser (10) mit großem Kern kommt, durch das Detektieren des Übergangs des Nanodrahts (40) von dem supraleitenden zu dem resistiven Zustand bei der Absorption eines Einzelphotons.

8. Einzelphotonendetektorvorrichtung nach einem der vorstehenden Ansprüche, wobei der Oberflächenbereich (45) einen Durchmesser in dem Bereich von 4-10 µm, vorzugsweise 6-9 µm, aufweist.

9. Verfahren zum Herstellen einer Einzelphotonendetektorvorrichtung (100), umfassend die Schritte:
- Ausbilden einer Verjüngung zwischen einer optischen Faser (10) mit großem Kern und einer optischen Faser (20) mit kleinem Kern, wobei die optische Faser (10) mit großem Kern einen Durchmesser des Kerns (11) aufweist, der größer als 8 µm ist, und die optische Faser (20) mit kleinem Kern einen Durchmesser des Kerns (21) aufweist, der kleiner als oder gleich 5 µm ist,
- Produzieren eines supraleitenden Nanodrahts (40), der einen Oberflächenbereich (45) aufweist, der konfiguriert ist, um alle Photonen zu empfangen, die von der optischen Faser (20) mit kleinem Kern emittiert werden,
- derartiges Platzieren des freien Endes der Faser (20) mit kleinem Kern relativ zu dem supraleitenden Nanodraht (40), dass in Verwendung alle Photonen, die von der optischen Faser (20) mit kleinem Kern emittiert werden, durch den Oberflächenbereich (45) des supraleitenden Nanodrahts empfangen werden, wobei der Schritt des Platzierens das stumpfe Koppeln des freien Endes der Faser (20) mit kleinem Kern mit dem supraleitenden Nanodraht (40) umfasst.

10. Verfahren nach dem vorstehenden Anspruch, wobei der Schritt des stumpfen Koppelns das stumpfe Koppeln des freien Endes (25) der Faser (20) mit kleinem Kern mit dem supraleitenden Nanodraht (40) unter Verwendung einer Gegenhülse (60) umfasst.

11. Verfahren nach einem der vorstehenden Verfahrensansprüche, wobei das Ausbilden einer Verjüngung das Ausbilden einer adiabatischen Verjüngung umfasst.

12. Verfahren nach einem der vorstehenden Verfahrensansprüche, wobei das Ausbilden einer Verjüngung das Zusammenspleißen der optischen Faser (10) mit großem Kern und der optischen Faser (20) mit kleinem Kern umfasst, wobei vorzugsweise der Schritt des Zusammenspleißens einer optischen Faser (20) mit kleinem Kern und einer optischen Faser (10) mit großem Kern ein Schmelzspleißen der Fasern mit einer Lichtbogenzeit zwischen 5000 ms und 8000 ms, stärker bevorzugt zwischen 5800 ms und 6200 ms, umfasst, wobei stärker bevorzugt das Schmelzspleißen bei einer Lichtbogenleistung in dem Bereich von 30 bis 45 Bit, vorzugsweise 37 Bit, durchgeführt wird.

13. Verfahren nach Anspruch 12, wobei der Schritt des Zusammenspleißens einer optischen Faser (20) mit kleinem Kern und einer optischen Faser (10) mit großem Kern vor dem Schmelzspleißen ferner die Schritte umfasst:
a) Schneiden jeder Faser (10, 20), Isolieren, Reinigen der Fasern (10, 20) von ihrer Schutzummantelung (12, 22),
b) Spalten der Fasern (10, 20) in einem zuvor bestimmten Spaltwinkel, vorzugsweise ferner umfassend den Schritt eines Überprüfens des Spaltwinkels und falls notwendig, Wiederholen der Schritte a) und b).

14. Verfahren nach einem der vorstehenden Verfahrensansprüche, ferner umfassend ein Anschließen eines Detektionssystems (50), das konfiguriert ist, um ein Einzelphoton in der optischen Faser (20) mit großem Kern zu detektieren, durch das Detektieren des Übergangs des Nanodrahts (40) von dem supraleitenden zu dem resistiven Zustand bei der Absorption eines Einzelphotons, und/oder wobei der Schritt des Produzierens des supraleitenden Nanodrahts (40) ein Aufsprühen eines supraleitenden Materials auf einen Siliziumwafer, wobei der Wafer mit dielektrischen Materialien beschichtet ist, um einen Hohlraum auszubilden, ein Ätzen des Nanodrahts (40) in dem Hohlraum und das Ätzen des Siliziumwafers in schlüssellochförmige Chips (70) umfasst, die den Nanodraht (40) enthalten.

15. Einzelphotonendetektorvorrichtung, erhältlich durch das Verfahren nach einem der Ansprüche 9 bis 14.

## Revendications

1. Appareil de détection à photon unique (100) comprenant :
- une fibre optique à grande âme (10) ayant un diamètre d'âme (11) supérieur à 8 µm,
- une fibre optique à petite âme (20) ayant un diamètre d'âme (21) inférieur ou égal à 5 µm,
- un cône (30) entre la fibre optique à grande âme (10) et la fibre optique à petite âme (20),
- un nanofil supraconducteur (40) ayant une zone de surface (45) configurée pour recevoir tous les photons émis par la fibre optique à petite âme (20), dans lequel l'extrémité libre de la fibre optique à petite âme (20) est couplée bout à bout au nanofil supraconducteur (40).

2. Appareil de détection à photon unique selon l'une quelconque des revendications précédentes, dans lequel la fibre optique à petite âme (20) a un diamètre d'âme compris entre 1,5 µm et 4 µm, de préférence entre 1,6 µm et 3,8 µm.

3. Appareil de détection à photon unique selon l'une quelconque des revendications précédentes, dans lequel la fibre optique à petite âme (20) est l'une d'une fibre de la famille UHNA ou d'une fibre 980 HP.

4. Appareil de détection à photon unique selon l'une quelconque des revendications précédentes, dans lequel la fibre optique à grande âme (10) est une fibre SMF28, de préférence une SMF28-Ultra.

5. Appareil de détection à photon unique selon l'une quelconque des revendications précédentes, dans lequel le cône est un cône adiabatique.

6. Appareil de détection à photon unique selon l'une quelconque des revendications précédentes, dans lequel le cône est formé par une épissure, de préférence, dans lequel l'épissure (30) est configurée pour avoir des pertes de transmission inférieures à 8 pour cent.

7. Appareil de détection à photon unique selon l'une quelconque des revendications précédentes, comprenant en outre un système de détection (50) configuré pour détecter un photon unique à partir de la fibre optique à grande âme (10), en détectant la transition du nanofil (40) de l'état supraconducteur à l'état résistif lors de l'absorption d'un photon unique.

8. Appareil de détection à photon unique selon l'une quelconque des revendications précédentes, dans lequel la zone de surface (45) a un diamètre compris dans la plage allant de 4 à 10 µm, de préférence de 6 à 9 µm.

9. Procédé de fabrication d'un appareil de détection à photon unique (100), comprenant les étapes suivantes consistant à :
- former un cône entre une fibre optique à grande âme (10) et une fibre optique à petite âme (20), la fibre optique à grande âme (10) ayant un diamètre d'âme (11) supérieur à 8 µm et la fibre optique à petite âme (20) ayant un diamètre d'âme (21) inférieur ou égal à 5 µm,
- fabriquer un nanofil supraconducteur (40) ayant une zone de surface (45) configurée pour recevoir tous les photons émis par la fibre optique à petite âme (20),
- mettre l'extrémité libre de la fibre à petite âme (20) par rapport au nanofil supraconducteur (40) de sorte que, lors de l'utilisation, tous les photons émis par la fibre optique à petite âme (20) soient reçus par la zone de surface (45) du nanofil supraconducteur, dans lequel l'étape de mise comprend le couplage bout à bout de l'extrémité libre de la fibre à petite âme (20) au nanofil supraconducteur (40).

10. Procédé selon la revendication précédente, dans lequel l'étape de couplage bout à bout comprend le couplage bout à bout de l'extrémité libre (25) de la fibre à petite âme (20) au nanofil supraconducteur (40) à l'aide d'un manchon d'accouplement (60).

11. Procédé selon l'une quelconque des revendications précédentes, dans lequel la formation d'un cône comprend la formation d'un cône adiabatique.

12. Procédé selon l'une quelconque des revendications précédentes, dans lequel la formation d'un cône comprend l'épissure de la fibre optique à grande âme (10) et de la fibre optique à petite âme (20), dans lequel, de préférence, l'étape consistant à épisser ensemble une fibre optique à petite âme (20) et une fibre optique à grande âme (10) comprend l'épissure par fusion des fibres avec un temps de fusion compris entre 5 000 ms et 8 000 ms, plus préférablement entre 5 800 ms et 6 200 ms, dans lequel, plus préférablement, l'épissure par fusion est effectué à une énergie de fusion comprise dans la plage allant de 30 à 45 bits, de préférence de 37 bits.

13. Procédé selon la revendication 12, dans lequel l'étape consistant à épisser ensemble une fibre optique à petite âme (20) et une fibre optique à grande âme (10) comprend en outre, avant l'épissure par fusion, les étapes consistant à :
a) couper chaque fibre (10, 20), dénuder, nettoyer les fibres (10, 20) de leur revêtement protecteur (12, 22),
b) fendre les fibres (10, 20) selon un angle de fendage prédéterminé, de préférence, comprenant en outre l'étape consistant à vérifier l'angle de fendage et, et si nécessaire, à répéter les étapes a) et b).

14. Procédé selon l'une quelconque des revendications précédentes, comprenant en outre la connexion d'un système de détection (50) configuré pour détecter un photon unique dans la fibre optique à grande âme (20), en détectant la transition du nanofil (40) de l'état supraconducteur à l'état résistif lors de l'absorption d'un photon unique, et/ou dans lequel l'étape consistant à fabriquer le nanofil supraconducteur (40) comprend la pulvérisation d'un matériau supraconducteur sur une plaquette de silicium, la plaquette étant recouverte de matériaux diélectriques afin de former une cavité, la gravure du nanofil (40) dans la cavité et la gravure de la plaquette de silicium en puces (70) en forme de trou de serrure contenant le nanofil (40).

15. Appareil de détection à photon unique pouvant être obtenu par le procédé selon l'une quelconque des revendications 9 à 14.
